# EUROPEAN PATENT APPLICATION

(11) **EP 2 281 919 A1**
(43) Date of publication of application: **09.02.2011**
(21) Application number: 09758236.5
(22) Date of filing: 26.05.2009
(51) Int. Cl.: C23C 14/34, C04B 35/453, C23C 14/08

(54) **SPUTTERING TARGET AND NON-CRYSTALLINE OPTICAL THIN FILM**

(30) Priority: 03.06.2008 JP 2008145243
(71) Applicant: JX Nippon Mining & Metals Corporation, Tokyo 100-8164 (JP)
(72) Inventor: TAKAMI Hideo, Kitaibaraki-shi Ibaraki 319-1535 (JP); YAHAGI Masataka, Kitaibaraki-shi Ibaraki 319-1535 (JP)
(74) Representative: Hoarton, Lloyd Douglas Charles
(86) International application number: PCT/JP2009/059567
(87) International publication number: WO 2009/147969

(57) **Abstract**

Disclosed is a sputtering target for forming an optical thin film formed of oxides of four elements of indium, tin, zinc and magnesium and comprising a compound phase of (In₂O₃) (ZnO)m (wherein 1 ≦ m ≦ 10) and (In₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%. A target formed of an In₂O₃-ZnO-SnO₂ composite oxide can be improved. Specifically, provided is a sputtering target capable of improving the extinction coefficient in the blue laser region around 400 nm of the sputtered film and that is used for forming an optical thin film having a stable amorphous nature, and an amorphous optical thin film that is deposited on a substrate using the target.

## Description

### TECHNICAL FIELD

The present invention relates to a sputtering target capable of improving the extinction coefficient in the blue laser region around 400 nm of the sputtered film and which is used for forming an optical thin film having a stable amorphous nature, and an amorphous optical thin film that is deposited on a substrate using the target

### BACKGROUND ART

Conventionally, a ZnS-SiO₂ film is generally used primarily as a protective layer of a phase-change optical information recording medium. The ZnS-SiO₂ film is characterized in having superior optical characteristics, heat characteristics, and adhesiveness with a recording layer. Nevertheless, with present-day rewritable DVDs as represented with Blu-Ray disks, further increase of the rewrite cycle, greater capacity, and faster recording are being strongly demanded.

As one cause of the deterioration in the rewrite cycle of the optical information recording medium, there is the diffusion of the sulfur component from the ZnS-SiO₂ to the recording layer material that is disposed in a manner of being sandwiched between the ZnS-SiO₂ protective layers.
Moreover, although pure Ag or Ag alloy having high reflectivity and high thermal conductive properties is now being used as the reflective layer material in order to achieve greater capacity and faster recording, this kind of reflective layer is also disposed in a manner of coming in contact with ZnS-SiO₂ as the protective layer material. Accordingly, in the foregoing case also, the diffusion of the sulfur component from the ZnS-SiO₂ will cause the corrosion of the pure Ag or Ag alloy reflective layer material, and deteriorate the characteristics such as the reflectance of the optical information recording medium.

As measures for preventing the diffusion of the sulfur component, an intermediate layer having nitrides or carbides as its primary component is sometimes provided between the reflective layer and the protective layer, and between the recording layer and the protective layer. Nevertheless, this method results in the increase in the number of laminations and entails problems such as deterioration of throughput and cost increase. In order to overcome the foregoing problems, demanded is substitution of a conventional material with a material of only oxides which is free from sulfides as the protective layer material, and a material system having optical characteristics and amorphous stability equal to or more favorable than ZnS-SiO₂.

In addition, since a ceramic target of ZnS-SiO₂ or the like has a high bulk electric resistivity, deposition cannot be performed using a DC sputtering device, and a standard radio frequency sputtering (RF) device is being used. Nevertheless, besides the radio frequency sputtering (RF) device being expensive, it entails numerous drawbacks such as the sputtering efficiency being inferior, power consumption being great, operational control being difficult, and the deposition rate being slow.
Moreover, if high power is applied in order to increase the deposition rate, the substrate temperature will rise and there is a problem in that the polycarbonate substrate will deform. Further, ZnS-SiO₂ also entails problems such as deterioration of throughput and cost increase due to the film thickness being thick.

In light of the above, proposed is a transparent conductive material that does not use ZnS; that is, which does not contain a sulfur component (refer to Patent Documents 1 and 2). Nevertheless, Patent Document 1 has problems in that it includes a region where the optical characteristics and the amorphous nature are inferior, and Patent Document 2 has problems in that it includes a region where the amorphous nature is inferior and a sufficient deposition rate cannot be obtained.
In consideration of the above, the present inventors substituted a conventional material with a material of only oxides that is free of sulfides as the protective layer material, and developed a sputtering target for an optical information recording medium formed of a material obtained by adding one type or two types of oxides of either SiO₂ or B₂O₃ to the In₂O₃-ZnO-SnO₂ composite oxide having SnO₂ as its primary component. This discovery yields a superior feature of being able to ensure optical characteristics and amorphous stability that are equal to ZnS-SiO₂ and additionally enables high-speed deposition.
[Patent Document 1] Japanese Published Unexamined Application No.2000-256059
[Patent Document 2] Japanese Published Unexamined Application No.2000-256061
[Patent Document 3] International Publication WO2005/078153

### DISCLOSURE OF THE INVENTION

### [Problems Which the Invention Intends to Solve]

An object of the present invention is to improve a target formed of fn₂O₃-ZnO-SnO₂ composite oxide, and to provide a sputtering target capable of improving the extinction coefficient in the blue laser region around 400 nm of the sputtered film and which is used for forming an optical thin film having a stable amorphous nature, and an amorphous optical thin film that is deposited on a substrate using the target.

### [Means for Solving the Problems]

In order to achieve the foregoing object, as a result of intense study, the present inventors discovered that it is possible to improve the extinction coefficient in the blue laser region around 400 nm of the sputtered film and form an optical thin film having a stable amorphous nature by adding magnesium oxide.

Based on the foregoing discovery, the present invention provides:
1) A sputtering target for forming an optical thin film formed of oxides of four elements of indium, tin, zinc and magnesium and comprising a compound phase of (in₂O₃) (ZnO)m (wherein 1 ≦ m ≦ 10) and (In₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%.

The present invention additionally provides:
2) An amorphous optical thin film deposited on a substrate by sputtering a target formed of oxides of four elements of indium, tin, zinc and magnesium and comprising a compound phase of (In₂O₃) (ZnO)m (wherein 1 ≦ m ≦10) and (in₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%; and
3) The amorphous optical thin film according to paragraph 2) above, wherein the refractive index in a wavelength of 400 nm is 2.0 or more, and the extinction coefficient is 0.1 or less.

### [Effect of the Invention]

According to the above, the present invention yields a significant feature of enabling to provide a sputtering target capable of improving the extinction coefficient in the blue laser region around 400 nm of the sputtered film and which is used for forming an optical thin film having a stable amorphous nature, and an amorphous optical thin film that is deposited on a substrate using the target.
In addition, the present invention is able to use, as is, the characteristics of the target formed of the previously developed In₂O₃-ZnO-SnO₂ composite oxide. Specifically, the target of the present invention enables high-speed deposition by way of sputtering, and the deposited thin film has superior adhesiveness with the recording layer, superior mechanical properties, high transmittance, and, as a result of being composed of a non-sulfide system, it possesses the characteristics of a thin film for an optical information recording medium (especially used as a protective film) in which the adjacent reflective layer and recording layer will not deteriorate easily.
Thus, it is possible to improve the characteristics of the optical information recording medium, as well as considerably improve the productivity thereof.

### BEST MODE FOR CARRYING OUT THE INVENTION

The sputtering target of the present invention is a sputtering target for forming an optical thin film formed of oxides of four elements of indium, tin, zinc and magnesium and comprising a compound phase of (In_{2O3)} (ZnO)m (wherein 1 ≦ m ≦ 10) and (In₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%. (In₂O₃) (ZnO)m and (In₂O₃) (MgO)n are a homologous phase.
Since this material has stable optical characteristics and the amorphous nature of the film is also stable, the sputtered film is able to improve the extinction coefficient in the blue laser region around 400 nm of the sputtered film, and cause the extinction coefficient to be 0.1 or less. Moreover, this material can cause the refractive index to be 2.0 or more in the same region.
This is particularly suitable as a protective layer material of a phase-change optical recording medium, and the sputter deposition rate by way of radio frequency sputtering is also fast.
This is considered to be a result of the addition of appropriate amounts of magnesium oxide and tin oxide, and, since the amorphous nature can be stabilized and the transmittance can be improved, it is suitable for use as a protective layer material in a phase-change recording medium having a fast rewriting rate or a blue laser phase-change recording medium.

With laser writing, the temperature usually reaches approximately 300 to 600°C, and a temperature cycle of this temperature and room temperature is repeated. Maintaining the amorphous nature under such circumstances is required.
Generally, in order to confirm that a protective layer for a phase-change recording medium possesses the durability of such temperature cycle, the annealing treatment (heating) test at 600°C described later is effective. Maintaining a high refractive index and a low extinction coefficient under the foregoing conditions is also necessary.
As an effective component for achieving the foregoing conditions, in particular the addition of magnesium oxide (MgO) can be considered, and it is extremely effective to set the magnesium content in relation to the total amount based on MgO conversion to be 3 to 25 mol%. Meanwhile, tin oxide (SnO₂) is effective for improving the deposition rate, and is also a necessary component.
Moreover, the sputtering target of the present invention is able to achieve a relative density of 90% or higher, and even 95% or higher. The improvement of density yields the effect of improving the uniformity of the sputtered film, and inhibiting the generation of particles during sputtering.

The sputtering target described above can be used for at least forming an optical thin film, and, specifically, can provide an optical information recording medium for forming a part of the optical information recording medium structure. Moreover, the foregoing sputtering target may be used to form a part of the structure of the optical information recording medium at least as a thin film, and prepare an optical information recording medium disposed adjacent to the recording layer or the reflective layer.
With the use of a material formed of indium oxide, tin oxide, zinc oxide, and magnesium oxide as described above, the present invention is able to possess a certain level of conductivity and, consequently, the deposition rate can be improved based on radio frequency sputtering. The bulk electric resistivity can be set to 0.1 Ωcm or less.
In addition, since the film thickness of the protective film itself can also be made thin, the present invention additionally yields the effect of being able to improve the productivity and prevent the heating of the substrate.

Moreover, the thin film that is formed by using the sputtering target of the present invention is able to form a part of the structure of the optical information recording medium and be disposed adjacent to the recording layer or the reflective layer. However, as described above, since ZnS is not used, significant effects are yielded in that it is free from contamination by sulfur (S), the diffusion of the sulfur component to the recording layer material disposed in a manner of being sandwiched between the protective layers can be prevented, and the consequent deterioration of the recording layer can also be prevented.
Moreover, although pure Ag or Ag alloy having high reflectivity and high thermal conductive properties is now being used as the reflective layer material in order to achieve greater capacity and faster recording, the diffusion of the sulfur component to the adjacent reflective layer can be prevented, and, similarly, the present invention yields a superior effect of being able to sweep away the cause which corrodes the pure Ag or Ag alloy reflective layer material and deteriorates the characteristics such as the reflectance of the optical information recording medium.

The sputtering target of the present invention can be produced by performing pressureless sintering or high temperature pressure sintering to the oxide powers of the respective constituent elements having an average grain size of 5 µm or less. Consequently, it is possible to obtain a sputtering target having a relative density of 90% or higher, and even 95% or higher. In the case, preferably calcinating the oxide powders before sintering is at 800 to 1300°C. After the calcination, the oxide powders can be pulverized to 3 µm or less and used as the raw material for sintering.
Moreover, after separating and calcinating In₂O₃-SnO₂-ZnO and In₂O₃-MgO, it is also possible to make adjustments by way of mixing. Incidentally, although the grain size of the oxide powders is desirably small as described above, there is no need to particularly limit the numerical value thereof. The grain size may be changed according to the intended quality of the target.

Further, the use of the sputtering target of the present invention improves productivity, enables to obtain a material with superior quality, and yields a significant effect of inexpensively producing an optical recording medium having an optical disk protective film. Particularly, it is possible to provide a sputtering target capable of improving the extinction coefficient in the blue laser region around 400 nm of the sputtered film and which is used for forming an optical thin film having a stable amorphous nature.
In addition, the improvement in density of the sputtering target of the present invention enables to reduce pores, refine the crystal grains, and cause the sputtered surface of the target to be uniform and smooth. Accordingly, the present invention yields a significant effect of reducing the generation of particles and nodules during sputtering, prolong the target life, and improve the mass productivity without much variation in the quality.

### [Examples]

The present invention is now explained with reference to the Examples and Comparative Examples. These Examples are merely illustrative, and the present invention shall in no way be limited thereby. In other words, the present invention can be limited only by claims, and various modifications and other embodiments shall be included as a matter of course.

### (Examples 1 to 7)

In₂O₃ powder, SnO₂ powder, ZnO powder, and MgO powder of 5 µm or less and equivalent to 4N were prepared, blended to achieve the compositions shown in Table 1, wet blended, dried, and thereafter calcinated at 1100°C.
In addition, the calcinated powder was subject to wet pulverization up to an average grain size of 1 µm, and granulated with a spray dryer upon adding a binder. The granulated powder was subject to cold pressure forming, further subject to pressureless sintering under an oxygen atmosphere at 1500°C, and this sintered material was subject to machining to obtain a target shape. The constituent components and composition ratio of the targets are shown in Table 1.

**[Table 1]**

| | Composition | | | | Homologous Phase | Relative Density(%) | Bulk Electric Resistivity | Abnormal Discharge | Amorphous Nature | Refractive Index | Extinction Coefficient |
|---|---|---|---|---|---|---|---|---|---|---|---|
| | In₂O₃ | SnO₂ | ZnO₂ | MgO | | | | | | | |
| Example1 | 23 | 20 | 50 | 7 | In₂O₃(ZnO)₃, In₂O₃(MgO) | 98 | 0.01 | None | O | 2.15 | 0.06 |
| Example2 | 10 | 8 | 70 | 12 | In₂O₃(ZnO)₅, In₂O₃(MgO) | 99 | 0.02 | None | O | 2.09 | 0.04 |
| Example3 | 10 | 10 | 60 | 20 | In₂O₃(ZnO)₅, In₂O₃(MgO)₂ | 95 | 0.08 | None | O | 2.01 | 0.01 |
| Comparative Example 1 | 1 | 10 | 80 | 9 | None | 92 | 0.05 | Crack | - | - | - |
| Comparative Example 2 | 5 | 40 | 50 | 5 | In₂O₃(ZnO)₁₀ | 97 | 0.05 | occurred | O | 2.28 | 0.21 |
| Comparative Example 3 | 10 | 2 | 78 | 10 | In₂O₃(ZnO)₅, In₂O₃(MgO) | 95 | 0.06 | None | × | 2.21 | 0.02 |
| Comparative Example 4 | 10 | 10 | 50 | 30 | In₂O₃(ZnO)₅, In₂O₃n(MgO)₂ | 90 | 1.53 | occurred | O | 1.91 | 0.01 |
| Comparative Example 5 | 10 | 10 | 79 | 1 | In₂O₃(ZnO)₅ | 97 | 0.01 | None | O | 2.23 | 0.12 |

Sputtering was performed using a 6-inch φ size target that was finished as described above. The sputtering conditions were as follows: RF sputtering, sputtering power of 1000W and Ar gas pressure of 0.5Pa, and deposition was performed with a target film thickness of 1500 Å.
The density, bulk electric resistivity (four-terminal method, Ωcm), and status of abnormal discharge of the sintered compact target, transmittance (wavelength 400 nm) %, refractive index (wavelength 400 nm), and amorphous nature (represented as the maximum peak intensity ratio in relation to an undeposited glass substrate in a range of 2θ = 20-60° based on the measurement by XRD (Cu-Kα, 40kV, 30mA) upon performing the annealing treatment (600°C × 30 min, Ar atmosphere) of the deposition sample. In Table 1, 1 to 2 is indicated with a O, and 2 or more is indicated with a × of the deposition sample, as well as the sputtering method and the measurement results of the deposition rate (Å/sec) are collectively shown in Table 1. Incidentally, the wavelength 400 nm is a wavelength of a blue laser region.

Thus, with the sputtering targets comprising appropriate amounts of In₂O₃, SnO₂, ZnO and MgO and (In₂O₃) (ZnO)m and (In₂O₃) (MgO)n as the homologous phase of Examples 1 to 7, they all achieved a relative density of 90 to 99%, and stable DC sputtering was enabled. In addition, a deposition rate of 1.5 to 3.2 Å/sec was achieved, and extremely favorable sputtering characteristics were realized.
The transmittance of the sputtered film reached 92 to 98% (633 nm), the refractive index was 2.00 to 2.19, no specific crystal peak could be observed, and a stable amorphous nature was yielded. In addition, the extinction coefficient was 0.01 to 0.09, and all cases showed a favorable extinction coefficient of 0.1 or less.
Since the targets of the Examples do not use ZnS, characteristics of the optical information recording medium will not deteriorate due to the diffusion and contamination of sulfur. In addition, in comparison to the Comparative Examples described later, the transmittance, refractive index and amorphous stability of the deposition sample, target density, and deposition rate all showed favorable values.

### (Comparative Examples 1 to 5)

As shown in Table 1, materials having the components and composition ratio of raw material powders that are different from the conditions of the present invention, in particular raw material powders in which the formation of the homologous phase is insufficient in Comparative Example 1 were prepared, such materials were used to prepare targets under the same conditions as the Examples, and such targets were used to form a sputtered film.
The results are similarly shown in Table 1.

With the components and compositions of the Comparative Examples that deviate from the composition ratio of the present invention, with respect to Comparative Example 1 for example, since it fails to comprises a homologous phase, abnormal discharge occurred and the target had cracked. Consequently, it was not possible to perform the deposition.
With Comparative Example 2, since the amount of In oxide was small, that of Sn oxide was large, and further it failed to comprise a homologous phase of (In₂O₃) (MgO)n, abnormal discharge occurred easily, and the extinction coefficient was 0.21, which did not satisfy the requirement of the present invention although it possessed an amorphous nature; specifically, an extinction coefficient of 0.1 or less.
With Comparative Example 3, the amount of ZnO was large and that of Sn oxide was small, this resulted in the amorphous nature being lost. In addition, it also had a problem in that the deposition rate deteriorated.
With Comparative Example 4, since the amount of magnesium oxide was large, the bulk electric resistivity increased, abnormal discharge occurred, the refractive index decreased, and the characteristics deviated from the object of the present invention.
With Comparative Example 5, since the amount of magnesium oxide was contrarily too small, the extinction coefficient was 0.12, which did not satisfy the requirement of the present invention; specifically, an extinction coefficient of 0.1 or less.

### INDUSTRIAL APPLICABILITY

The present invention yields a significant feature of enabling to provide a sputtering target capable of improving the extinction coefficient in the blue laser region around 400 nm of the sputtered film and which is used for forming an optical thin film having a stable amorphous nature, and an amorphous optical thin film that is deposited on a substrate using the target.
In addition, the present invention is able to use, as is, the characteristics of the target formed of the previously developed In₂O₃-ZnO-SnO₂ composite oxide. Specifically, the target of the present invention enables high-speed deposition by way of sputtering, and the deposited thin film has superior adhesiveness with the recording layer, superior mechanical properties, high transmittance, and, as a result of being composed of a non-sulfide system, it possesses the characteristics of a thin film for an optical information recording medium (especially used as a protective film) in which the adjacent reflective layer and recording layer will not deteriorate easily It is thereby possible to improve the characteristics of the optical information recording medium, and considerably improve the productivity thereof.
Accordingly, the present invention is effective as a sputtering target for forming an amorphous optical thin film, in particular a protective layer of a phase-change optical information recording medium.

## Claims

1. A sputtering target for forming an optical thin film formed of oxides of four elements of indium, tin, zinc and magnesium and comprising a compound phase of (In₂O₃) (ZnO)m (wherein 1 ≦ m ≦ 10) and (In₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%.

2. An amorphous optical thin film deposited on a substrate by sputtering a target formed of oxides of four elements of indium, tin, zinc and magnesium and comprising a compound phase of (In₂O₃) (ZnO)m (wherein 1 ≦ m ≦ 10) and (In₂O₃) (MgO)n (wherein 1 ≦ n ≦ 2), wherein the tin content in relation to the total amount based on SnO₂ conversion is 5 to 30 mol%, and the magnesium content in relation to the total amount based on MgO conversion is 3 to 25 mol%.

3. The amorphous optical thin film according to claim 2, wherein the refractive index in a wavelength of 400 nm is 2.0 or more, and the extinction coefficient is 0.1 or less.
